(19) Europäisches Patentamt
European Patent Office
Office européen des brevets

(11) **EP 4 707 833 A1**

(12) **EUROPEAN PATENT APPLICATION**
published in accordance with Art. 153(4) EPC

(43) Date of publication:
**11.03.2026 Bulletin 2026/11**

(21) Application number: **24815716.6**

(22) Date of filing: **24.04.2024**

(51) International Patent Classification (IPC):
*G01R 31/392* (2019.01)    *G01R 31/396* (2019.01)
*G01R 31/385* (2019.01)    *G01R 19/00* (2006.01)
*G01R 19/165* (2006.01)    *G01R 19/30* (2006.01)
*G01R 31/374* (2019.01)    *H01M 10/0525* (2010.01)
*B60L 58/16* (2019.01)

(52) Cooperative Patent Classification (CPC):
Y02E 60/10

(86) International application number:
**PCT/KR2024/005541**

(87) International publication number:
**WO 2024/248337 (05.12.2024 Gazette 2024/49)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.05.2023 KR 20230068627**

(71) Applicant: **LG Energy Solution, Ltd.
Seoul 07335 (KR)**

(72) Inventor: **SUNG, Yong Chul
Daejeon 34122 (KR)**

(74) Representative: **Plasseraud IP
104 Rue de Richelieu
CS92104
75080 Paris Cedex 02 (FR)**

(54) **BATTERY MANAGEMENT APPARATUS AND OPERATION METHOD THEREFOR**

(57)    A battery management apparatus according to an embodiment disclosed herein includes a voltage measurement unit configured to measure a voltage of each of a plurality of batteries and a controller configured to calculate a first deviation, which is a deviation between a long moving average and a short moving average of a battery voltage for each of the plurality of batteries, calculate a second deviation, which is a deviation between a long moving average and a short moving average of an average voltage of the plurality of battery cells, and calculate a first diagnosis deviation between the first deviation and the second deviation for each of the plurality of battery cells, calculate an accumulative deviation by accumulating the first diagnosis deviation when the first diagnosis deviation of at least one of the plurality of batteries exceeds a threshold value, and diagnose at least one of the plurality of batteries as an abnormal battery, based on the accumulative deviation.

200

| VOLTAGE MEASUREMENT UNIT 210 |——| CONTROLLER 220 |

FIG.2

## Description

**[Technical Field]**

CROSS-REFERENCE TO RELATED APPLICATION

This application claims priority to and the benefit of Korean Patent Application No. 10-2023-0068627 filed in the Korean Intellectual Property Office on May 26, 2023, the entire content of which is incorporated herein by reference.

TECHNICAL FIELD

Embodiments disclosed herein relate to a battery management apparatus and an operating method thereof.

**[Background Art]**

An electric vehicle is supplied with electricity from outside to charge a battery cell, and then a motor is driven by a voltage charged in the battery cell to obtain power. A battery cell undergoes internal deformation and degeneration through various charging and discharging during production and use, with physical/chemical characteristics thereof changing, resulting in venting due to internal short-circuit, external short-circuit, and lithium precipitation or in an under-voltage defect in which a voltage of a battery cell decreases below a certain level.

When a defect occurs inside the battery cell, direct problems may occur in the battery cell, such as deterioration of battery cell performance, the increased possibility of ignition due to leakage of an electrolyte, etc. Thus, a technique for determining whether the battery cell is abnormal is required.

A conventional battery management apparatus may diagnose voltage abnormality of a battery cell by using a voltage deviation of an individual battery cell with respect to an average voltage of battery cells, but this method may not adjust a threshold that is a criterion for diagnosing an abnormal battery cell below a certain level due to its vulnerability to noise, and may not detect an abnormal voltage of a battery cell due to micro-disconnection occurring in an electric vehicle.

**[Disclosure]**

**[Technical Problem]**

Embodiments disclosed herein aim to provide a battery management apparatus and an operating method thereof in which noise of a deviation between a long moving average and a short moving average of a voltage of a battery may be removed to accurately diagnose an abnormal battery cell.

Technical problems of the embodiments disclosed herein are not limited to the above-described technical problems, and other unmentioned technical problems would be clearly understood by one of ordinary skill in the art from the following description.

**[Technical Solution]**

A battery management apparatus according to an embodiment disclosed herein includes a voltage measurement unit configured to measure a voltage of each of a plurality of batteries and a controller configured to calculate a first deviation, which is a deviation between a long moving average and a short moving average of a battery voltage for each of the plurality of batteries, calculate a second deviation, which is a deviation between a long moving average and a short moving average of an average voltage of the plurality of battery cells, and calculate a first diagnosis deviation between the first deviation and the second deviation for each of the plurality of battery cells, calculate an accumulative deviation by accumulating the first diagnosis deviation when the first diagnosis deviation of at least one of the plurality of batteries exceeds a threshold value, and diagnose at least one of the plurality of batteries as an abnormal battery, based on the accumulative deviation.

According to an embodiment, the controller may be further configured to set, as a reference value, a maximum value between a value, obtained by multiplying the second deviation by a first threshold constant, and a second threshold constant and calculate a second diagnosis deviation of each of the plurality of batteries by excluding a first diagnosis deviation less than or equal to the reference value among first diagnosis deviations of the plurality of batteries.

According to an embodiment, the controller may be further configured to perform normalization by dividing the second diagnosis deviation of each of the plurality of battery cells by a maximum value between a value, obtained by multiplying the second deviation by a third threshold constant, and a fourth threshold constant to calculate a third diagnosis deviation of each of the plurality of battery cells.

According to an embodiment, the controller may be further configured to calculate a skewness of each of the plurality of batteries by dividing a value, obtained by adding a minimum value of the third diagnosis deviation to the third diagnosis deviation of each of the plurality of batteries, by the third diagnosis deviation.

According to an embodiment, the controller may be further configured to calculate a fourth diagnosis deviation of each of the plurality of batteries by multiplying the third diagnosis deviation of each of the plurality of batteries by the skewness.

According to an embodiment, the controller may be further configured to, when a fourth diagnosis deviation of at least one of the plurality of batteries exceeds an upper threshold, calculate the accumulative deviation by accumulating a first diagnosis deviation of the at least one battery.

According to an embodiment, the controller may be further configured to calculate the accumulative deviation by accumulating the first diagnosis deviation of the at least one battery from a point when the fourth diagnosis deviation of the at least one of the plurality of batteries exceeds the upper threshold to a point when the first diagnosis deviation is less than or equal to a lower threshold.

According to an embodiment, the controller may be further configured to, when an accumulative deviation of at least one of the plurality of batteries exceeds a threshold deviation, diagnose the at least one battery as an abnormal battery.

According to an embodiment, the controller may be further configured to, when the accumulative deviation of the at least one of the plurality of batteries is less than or equal to the threshold deviation, diagnose the at least one battery as a noise battery.

An operating method of a battery management apparatus according to an embodiment disclosed herein includes measuring a voltage of each of a plurality of battery cells, calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells, setting a diagnosis battery cell by diagnosing at least one of the plurality of battery cells based on the first diagnosis deviation of each of the plurality of battery cells, and determining whether the diagnosis battery cell is diagnosed normally, by comparing a first diagnosis deviation of a battery cell having a maximum value among first diagnosis deviations of battery cells different from the diagnosis battery cell with the first diagnosis deviation of the diagnosis battery cell.

According to an embodiment, the calculating of the first diagnosis deviation between the first deviation and the second deviation for each of the plurality of battery cells may include setting, as a reference value, a maximum value between a value, obtained by multiplying the second deviation by a first threshold constant, and a second threshold constant and calculating a second diagnosis deviation of each of the plurality of batteries by excluding a first diagnosis deviation less than or equal to the reference value among first diagnosis deviations of the plurality of batteries.

According to an embodiment, the calculating of the first diagnosis deviation between the first deviation and the second deviation for each of the plurality of battery cells may include performing normalization by dividing the second diagnosis deviation of each of the plurality of batteries by a maximum value between a value, obtained by multiplying the second deviation by a third threshold constant, and a fourth threshold constant to calculate a third diagnosis deviation of each of the plurality of batteries.

According to an embodiment, the calculating of the first diagnosis deviation between the first deviation and the second deviation for each of the plurality of battery cells may include calculating a skewness of each of the plurality of batteries by dividing a value, obtained by adding a minimum value of the third diagnosis deviation to the third diagnosis deviation of each of the plurality of batteries, by the third diagnosis deviation.

According to an embodiment, the calculating of the first diagnosis deviation between the first deviation and the second deviation for each of the plurality of battery cells may include calculating a fourth diagnosis deviation of each of the plurality of batteries by multiplying the third diagnosis deviation of each of the plurality of batteries by the skewness.

According to an embodiment, the calculating of the accumulative deviation by accumulating the first diagnosis deviation when the first diagnosis deviation of at least one of the plurality of batteries exceeds the threshold value may include, when a fourth diagnosis deviation of at least one of the plurality of batteries exceeds an upper threshold, calculating the accumulative deviation by accumulating the first diagnosis deviation of the at least one battery.

According to an embodiment, the calculating of the accumulative deviation by accumulating the first diagnosis deviation when the first diagnosis deviation of at least one of the plurality of batteries exceeds the threshold value may include calculating the accumulative deviation by accumulating the first diagnosis deviation of the at least one battery from a point when the fourth diagnosis deviation of the at least one of the plurality of batteries exceeds the upper threshold to a point when the first diagnosis deviation is less than or equal to a lower threshold.

According to an embodiment, the diagnosing of the at least one of the plurality of batteries as the abnormal battery, based on the accumulative deviation, may include, when an accumulative deviation of at least one of the plurality of batteries exceeds a threshold deviation, diagnosing the at least one battery as an abnormal battery.

According to an embodiment, the diagnosing of the at least one of the plurality of batteries as the abnormal battery, based on the accumulative deviation, may include, when the accumulative deviation of at least one of the plurality of batteries is less than or equal to the threshold deviation, diagnosing the at least one battery as a noise battery.

[Advantageous Effects]

The battery management apparatus and the operating method thereof according to an embodiment disclosed herein may accurately diagnose an abnormal battery cell by removing noise of a deviation between a long moving average and a short moving average of a voltage of a battery.

[Description of Drawings]

FIG. 1 illustrates a battery pack according to an embodiment disclosed herein.
FIG. 2 is a block diagram illustrating a configuration of a battery management apparatus, according to an embodiment disclosed herein.
FIG. 3 is a graph showing a voltage of a battery cell according to an embodiment disclosed herein.
FIG. 4 is a flowchart illustrating a method of calculating a diagnosis deviation of a battery cell by a controller, according to an embodiment disclosed herein.
FIG. 5A is a graph showing a first diagnosis deviation of a battery cell according to an embodiment disclosed herein.
FIG. 5B is a graph showing a third diagnosis deviation of a battery cell according to an embodiment disclosed herein.
FIG. 5C is a graph showing a skewness of a third diagnosis deviation of a battery cell according to an embodiment disclosed herein.
FIG. 5D is a graph showing a fourth diagnosis deviation of a battery cell according to an embodiment disclosed herein.
FIG. 6 is a flowchart illustrating a method of diagnosing an abnormal battery cell by a controller, according to an embodiment disclosed herein.
FIG. 7A is a graph showing a voltage of an abnormal battery cell according to an embodiment disclosed herein.
FIG. 7B is a graph showing a voltage of a noise battery cell according to an embodiment disclosed herein.
FIG. 8A is a graph showing a first diagnosis deviation of an abnormal battery cell according to an embodiment disclosed herein.
FIG. 8B is a graph showing a first diagnosis deviation of a noise battery cell according to an embodiment disclosed herein.
FIG. 9 is a flowchart of an operating method of a battery management apparatus according to an embodiment disclosed herein.
FIG. 10 is a flowchart illustrating a method of calculating a diagnosis deviation of a battery cell by a battery management apparatus, according to an embodiment disclosed herein.
FIG. 11 is a flowchart illustrating a method of diagnosing an abnormal battery cell by a battery management apparatus, according to an embodiment disclosed herein.
FIG. 12 is a block diagram showing a hardware configuration of a computing system for performing an operating method of a battery management apparatus, according to an embodiment disclosed herein.

[Mode for Invention]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

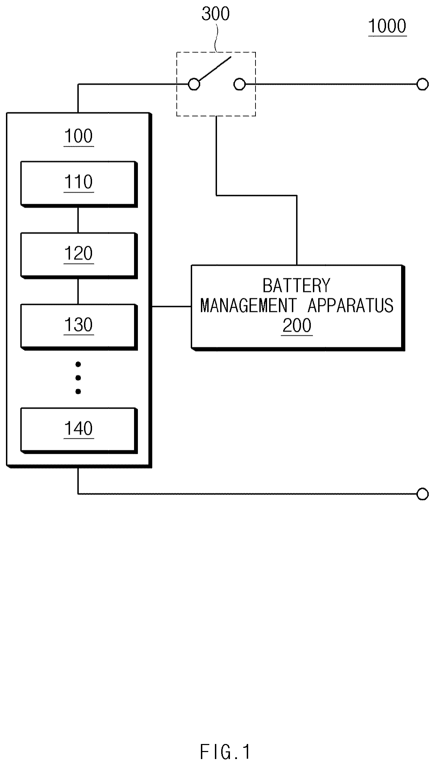

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

Meanwhile, although one battery module 100 is illustrated in FIG. 1, the battery module 100 may be configured in plural and the battery pack 1000 may have a stacked structure of a plurality of battery modules, according to an embodiment. The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2). Each of the plurality of battery cells 110, 120, 130, and 140 may be a cell group or a battery bank in which at least two battery cells are connected in parallel.

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus (a battery management system (BMS)) 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

For the plurality of battery cells 110, 120, 130, and 140, as a period of use or the number of times of use increases, a capacity may decrease, internal resistance may increase, and various factors of the battery may change. The battery management apparatus 200 may diagnose an abnormal phenomenon inside the plurality of battery cells 110, 120, 130, and 140 based on data of various factors changing with deterioration of the battery cells.

When a defect occurs in a battery cell due to various causes such as a detect in a production stage, internal deformation and degeneration through a plurality of charging and discharging, an external impact, etc., a voltage change may occur more quickly and significantly in comparison to a normal battery cell. By using a phenomenon in which a voltage change is faster and more significant in a battery cell having an internal defect occurring than in a normal battery cell in an idle period, the battery management apparatus 200 may compare voltage data of the idle period of each of the plurality of battery cells 110, 120, 130, and 140 with statistic normal voltage data of an idle period of a normal battery cell to diagnose an abnormal battery cell among the plurality of battery cells 110, 120, 130, and 140.

In the abnormal battery cell, a voltage drops in an idle period after charging when compared to a normal battery cell, and a greater deviation in voltage behavior occurs than a voltage behavior of the normal battery cell, such that the voltage behavior is biased to one side, resulting in a great skewness. The battery management apparatus 200 may determine whether there is an abnormal battery cell among the plurality of battery cells 110, 120, 130, and 140 by using a greater deviation and a greater skewness of the voltage behavior of the abnormal battery cell than those of the voltage behavior of the normal battery cell.

Specifically, the battery management apparatus 200 may calculate an average of voltages of the plurality of battery cells 110, 120, 130, and 140 and a deviation dV of the voltage of each of the plurality of battery cells 110, 120, 130, and 140. The battery management apparatus 200 may determine an abnormal behavior of a voltage of at least one battery cell among the plurality of battery cells 110, 120, 130, and 140 by using the deviation of the voltage of each of the plurality of battery cells 110, 120, 130, and 140.

The battery management apparatus 200 may calculate deviation data of the voltage of each of the plurality of battery cells 110, 120, 130, and 140 except for noise voltage data suspected to be noise data among the deviation of the voltage of each of the plurality of battery cells 110, 120, 130, and 140. The battery management apparatus 200 may amplify the voltage deviation data of each of the plurality of battery cells 110, 120, 130, and 140 after excluding the noise voltage data among the deviations of the voltages of the plurality of battery cells 110, 120, 130, and 140.

The battery management apparatus 200 may determine a battery cell suspected to have an abnormal voltage by using the amplified voltage deviation data of each of the plurality of battery cells 110, 120, 130, and 140, and then diagnose the battery cell as an abnormal battery cell by using an accumulative value of the voltage deviation data of the battery cell. When an abnormal battery cell is diagnosed by using a skewness of voltage deviation data of a battery cell, for even a battery cell having a greater voltage measurement noise, a signal of voltage deviation data is measured as having a greater value, failing to prevent false positives. Thus, the battery management apparatus 200 may use an accumulative value of voltage deviation data of a battery cell to reduce a false positive rate of a method of diagnosing an abnormal battery cell using a skewness of the voltage deviation data.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

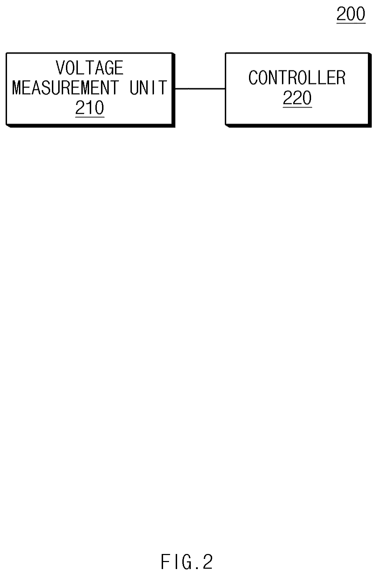

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a voltage measurement unit 210 and a controller 220.

The voltage measurement unit 210 may calculate the voltage of each of the plurality of battery cells 110, 120, 130, and 140. The voltage measurement unit 210 may calculate the voltage of each of the plurality of battery cells 110, 120, 130, and 140 for each unit time to calculate time-series data of the voltage of each of the plurality of battery cells 110, 120, 130, and 140. According to an embodiment, the voltage measurement unit 210 may continuously calculate voltage rise and drop and long-term relaxation data of the plurality of battery cells 110, 120, 130, and 140 in charging, an idle period after charging, discharging, and an idle period after discharging.

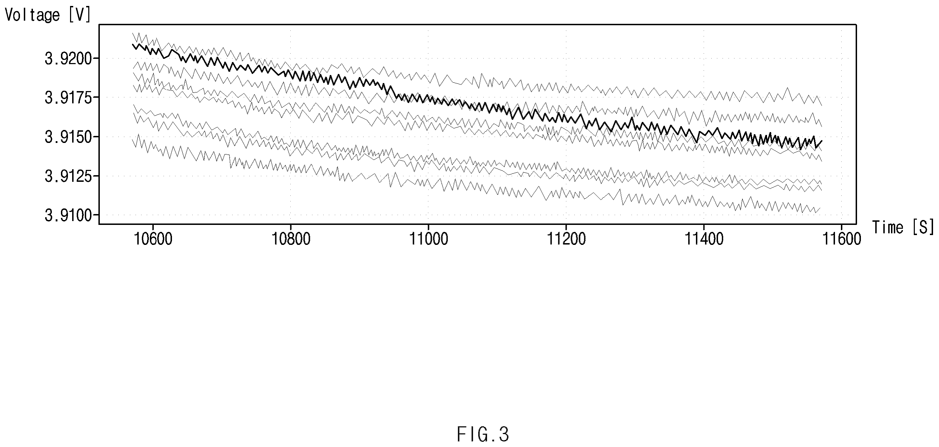

FIG. 3 is a graph showing a voltage of a battery cell according to an embodiment disclosed herein.

Referring to FIG. 3, the voltage measurement unit 210 may calculate the time-series data of the voltage of each of the plurality of battery cells 110, 120, 130, and 140 by measuring the voltages of the plurality of battery cells 110, 120, 130, and 140 in charging, an idle period after charging, discharging, and an idle period after discharging. The voltage measurement unit 210 may generate a graph indicating a voltage change of each of the plurality of battery cells 110, 120, 130, and 140 by measuring the voltage of each of the plurality of battery cells 110, 120, 130, and 140 for each unit time.

The controller 220 may calculate a moving average of the voltage of each of the plurality of battery cells 110, 120, 130, and 140. Herein, the moving average may be an average of some data extracted during movement on a window of a certain size among the entire data. Herein, the window may be a reference period for determining some of the entire data extracted for use. A start point of the window may be a point preceding the present point by a reference time, an end point of the window may be the present point. For example, when the window corresponds to one week, the controller 220 may extract data obtained during the recent one week from the present point from among the entire data.

The controller 220 may calculate the moving average of the voltage of each of the plurality of battery cells 110, 120, 130, and 140 by using voltage data extracted during movement in the window from among the entire voltage data of each of the plurality of battery cells 110, 120, 130, and 140. The controller 220 may calculate the continuous moving average of the voltage of each of the plurality of battery cells 110, 120, 130, and 140 by using voltage data continuously extracted during movement in the window from among the entire voltage data of each of the plurality of battery cells 110, 120, 130, and 140. For example, the controller 220 may calculate the moving average of the voltage of each of the plurality of battery cells 110, 120, 130, and 140 by applying any one of a simple moving average, a weighted moving average, or an exponential moving average (EMA) to the entire voltage data of each of the plurality of battery cells 110, 120, 130, and 140.

According to an embodiment, the controller 220 may calculate the EMA of the voltage of each of the plurality of battery cells 110, 120, 130, and 140 by applying the EMA to the entire voltage data of each of the plurality of battery cells 110, 120, 130, and 140. The EMA refers to a sort of weighted moving averaging in which a higher weight value is applied to the recent data, while using data of all the past periods.

The controller 220 may calculate a plurality of moving averages having different window sizes by using the voltage data of each of the plurality of battery cells 110, 120, 130, and 140. According to an embodiment, the controller 220 may calculate a long moving average having a long window length and a short moving average having a short window length by using the entire voltage data of each of the plurality of battery cells 110, 120, 130, and 140. For example, the window size of the long moving average may include 100 seconds, and the window size of the short moving average may include 10 seconds. For example, the controller 220 may calculate the long moving average of each of the plurality of battery cells 110, 120, 130, and 140 by using voltage data obtained during the recent 100 seconds from calculation using the voltage data of each of the plurality of battery cells 110, 120, 130, and 140, and calculate the short moving average of each of the plurality of battery cells 110, 120, 130, and 140 by using the voltage data obtained for the recent 10 seconds from the calculation.

The controller 220 may analyze a long voltage change trend and a short voltage change trend of each of the plurality of battery cells 110, 120, 130, and 140 by using continuous long moving average V_LMA and short moving average V_SMA of each of the plurality of battery cells 110, 120, 130, and 140. The controller 220 may diagnose whether a voltage of each of the plurality of battery cells is abnormal, by using the long moving average V_LMA and the short moving average V_SMA of each of the plurality of battery cells 110, 120, 130, and 140.

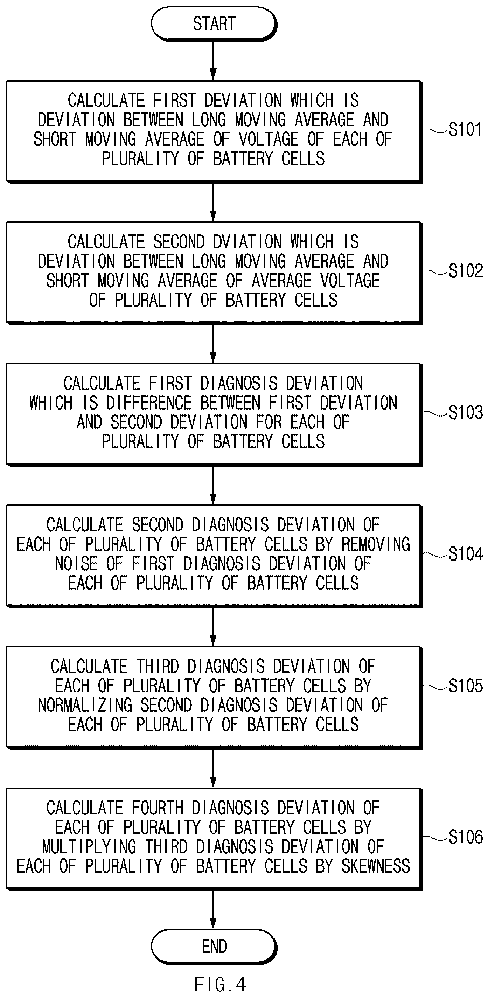

FIG. 4 is a flowchart illustrating a method of calculating a diagnosis deviation of a battery cell by a controller, according to an embodiment disclosed herein.

Hereinbelow, a method of calculating a diagnosis deviation of a battery cell by the controller will be described in detail with reference to FIG. 4.

In operation S101, the controller 220 may calculate a plurality of first deviations V_LMA - V_SMA which is a deviation of the long moving average V_LMA and the short moving average V_SMA of the voltage of each of the plurality of battery cells 110, 120, 130, and 140. In operation S101, the controller 220 may continuously calculate the first deviation V_LMA - V_SMA of each of the plurality of battery cells 110, 120, 130, and 140 calculated during a unit time. In operation S101, that is, the controller 220 may continuously calculate a deviation between a long behavior and a short behavior of each of the plurality of battery cells 110, 120, 130, and 140.

In operation S102, the controller 220 may calculate a long moving average V_avg_LMA and a short moving average V_avg_SMA of an average voltage V_avg of the plurality of battery cells 110, 120, 130, and 140. Herein, the average voltage V_avg of the plurality of battery cells 110, 120, 130, and 140 may include a mean, a median, or a minimum value of the voltages of the plurality of battery cells 110, 120, 130, and 140.

In operation S102, the controller 220 may continuously calculate the average voltage V_avg of the plurality of battery cells 110, 120, 130, and 140 for each unit time, and calculate the long moving average V_avg_LMA and the short moving average V_avg_SMA of the average voltage V_avg of the plurality of battery cells 110, 120, 130, and 140 by using the average voltage V_avg of the plurality of battery cells 110, 120, 130, and 140. Herein, a window size of the long moving average V_avg_LMA of the average voltage V_avg of the plurality of battery cells 110, 120, 130, and 140 may equal a window size of the long moving average V_LMA of the voltage of each of the plurality of battery cells 110, 120, 130, and 140. Herein, a window size of the short moving average V_avg_SMA of the average voltage V_avg of the plurality of battery cells 110, 120, 130, and 140 may equal a window size of the short moving average V_SMA of the voltage of each of the plurality of battery cells 110, 120, 130, and 140.

In operation S102, the controller 220 may calculate a second deviationV_avg_LMA - V_avg_SMA that is a deviation between the long moving average V_avg_LMA and the short moving average V_avg_SMA of the average voltage V_avg of the plurality of battery cells 110, 120, 130, and 140. In operation S102, the controller 220 may continuously calculate the second deviation V_avg_LMA - V_avg_SMA of the plurality of battery cells 110, 120, 130, and 140 for each unit time. That is, the controller 220 may calculate a deviation of a long behavior and a short behavior of the average voltage V_avg of the plurality of battery cells 110, 120, 130, and 140.

In operation S103, the controller 220 may calculate a first diagnosis deviation D1 of each of the plurality of battery cells 110, 120, 130, and 140, which is a deviation of the plurality of first deviations V_LMA - L_SMA and the second deviation V_avg_LMA - V_avg_SMA.

In operation S103, specifically, the controller 220 may calculate the first diagnosis deviation D1 of each of the plurality of battery cells 110, 120, 130, and 140, based on Equation 1.

First Diagnosis Deviation (D1) = Second Deviation - First Deviation = (V_avg_LMA - V_avg_SMA) - (V_LMA - V_SMA)     [Equation 1]

Referring to Equation 1, the controller 220 may calculate the deviation of the plurality of first deivations V_LMA - V_SMA and the second deviation V_avg_LMA - V_avg_SMA as the first diagnosis deviation D1 of each of the plurality of battery cells 110, 120, 130, and 140.

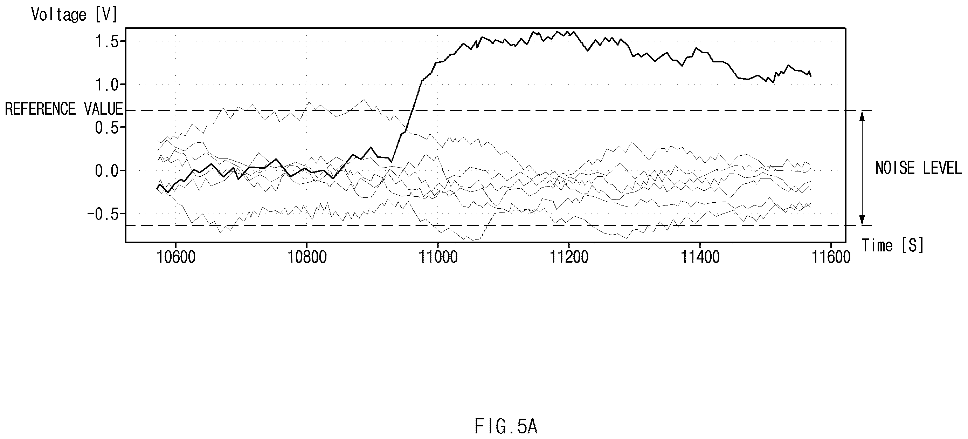

FIG. 5A is a graph showing a first diagnosis deviation of a battery cell according to an embodiment disclosed herein.

Referring to FIG. 5A, the controller 220 may continuously calculate the first diagnosis deviation D1 of each of the plurality of battery cells 110, 120, 130, and 140 for each unit time to generate a graph indicating a change in the first diagnosis deviation D1 of each of the plurality of battery cells 110, 120, 130, and 140.

That is, the controller 220 may calculate the first diagnosis deviation D1 of each of the plurality of battery cells 110, 120, 130, and 140 to compare a deviation of the long behavior and the short behavior of the voltage of each of the plurality of battery cells 110, 120, 130, and 140 with respect to a deviation of the long behavior and the short behavior of the average voltage V_avg of the plurality of battery cells 110, 120, 130, and 140.

Referring back to FIG. 4, in operation S104, the controller 220 may calculate a second diagnosis deviation D2 of each of the plurality of battery cells 110, 120, 130, and 140 by removing noise data from the first diagnosis deviation D1 of each of the plurality of battery cells 110, 120, 130, and 140.

In operation S104, specifically, the controller 220 may set a reference value for determining noise of the first diagnosis deviation D1 of each of the plurality of battery cells 110, 120, 130, and 140, based on Equation 2.

[Equation 2]

$$\text{Reference Value} = \text{Max}[|V\_avg\_LMA - V\_avg\_SMA| * C1, C2]$$

In operation S104, the controller 220 may set a maximum value Max between a value ($|V\_avg\_LMA - V\_avg\_SMA|*C1$) obtained by multiplying an absolute value of the second deviation ($V\_avg\_LMA - V\_avg\_SMA$) by a first threshold constant C1 and a a second threshold constant C2 as a reference value for each of the plurality of battery cells 110, 120, 130, and 140. Herein, the first threshold constant C1 may include '0.1', and the second threshold constant C2 may include '0.4'. The first threshold constant C1 and the second threshold constant C2 may change according to a size and characteristics of voltage data of each of the plurality of battery cells 110, 120, 130, and 140.

In operation S104, the controller 220 may determine the first diagnosis deviation D1 less than or equal to the reference value among the first diagnosis deviation D1 of each of the plurality of battery cells 110, 120, 130, and 140 as noise data. In operation S104, the controller 220 may calculate the second diagnosis deviation D2 of each of the plurality of battery cells 110, 120, 130, and 140 by excluding the first diagnosis deviation D1 less than or equal to the reference value among the first diagnosis deviation D1 of each of the plurality of battery cells 110, 120, 130, and 140.

In operation S105, the controller 220 may calculate a third diagnosis deviation D3 by normalizing the second diagnosis deviation D2 of each of the plurality of battery cells 110, 120, 130, and 140.

In operation S105, specifically, the controller 220 may calculate the third diagnosis deviation D3 of each of the plurality of battery cells 110, 120, 130, and 140 by normalizing the second diagnosis deviation D2 of each of the plurality of battery cells 110, 120, 130, and 140, based on Equation 3 below.

$$\text{Third Diagnosis Deviation} = \text{Second Diagnosis Deviation} / \text{Max}[|V\_avg\_LMA - V\_avg\_SMA| * C3, C4] \qquad \text{[Equation 3]}$$

In operation S105, the controller 220 may calculate a maximum value Max between a value $|V\_avg\_LMA - V\_avg\_SMA|*C3$ obtained by multiplying the absolute value $|V\_avg\_LMA - V\_avg\_SMA|$ of the second deviation by the third threshold constant C3 and a fourth threshold constant C4. The controller 220 may normalize the second diagnosis deviation D2 of each of the plurality of battery cells 110, 120, 130, and 140 by using the maximum value $\text{Max}[|V\_avg\_LMA - V\_avg\_SMA|*C3,C4]$ between the value obtained by multiplying the absolute value of the second deviation by the third threshold constant and the fourth threshold constant C4. Herein, the third threshold constant C3 may include '0.1', and the fourth threshold constant C4 may include '0.1', and the third threshold constant C3 and the fourth threshold constant C4 may change according to a size and characteristics of voltage data of each of the plurality of battery cells 110, 120, 130, and 140. In operation S105, the controller 220 may calculate, as the third diagnosis deviation D3 of each of the plurality of battery cells 110, 120, 130, and 140, a value obtained by normalizing the second diagnosis deviation D2 of each of the plurality of battery cells 110, 120, 130, and 140 by using the second deviation $V\_avg\_LMA - V\_avg\_SMA$ indicating a behavior of the average voltage V\_avg of the plurality of battery cells 110, 120, 130, and 140.

In operation S105, according to an embodiment, the controller 220 may normalize the second diagnosis deviation D2 of each of the plurality of battery cells 110, 120, 130, and 140 through a log operation. That is, the controller 220 may calculate, as the third diagnosis deviation D3 of each of the plurality of battery cells 110, 120, 130, and 140, a value obtained by normalizing the second diagnosis deviation D2 of each of the plurality of battery cells 110, 120, 130, and 140 through a log operation.

In operation S105, according to an embodiment, the controller 220 may set, as a normalization reference value, an average D2\_avg of the second diagnosis deviation D2 of each of the plurality of battery cells 110, 120, 130, and 140. In operation S105, the controller 220 may perform normalization by dividing the second diagnosis deviation D2 of each of the plurality of battery cells 110, 120, 130, and 140 by the average value D2\_avg of the second diagnosis deviation D2, by using the average D2\_avg of the second diagnosis deviation as a normalization reference value. That is, the controller 220 may calculate, as the third diagnosis deviation D3 of each of the plurality of battery cells 110, 120, 130, and 140, a value obtained through normalization by dividing the second diagnosis deviation D2 of each of the plurality of battery cells 110, 120, 130, and 140 by the average D2\_avg of the second diagnosis deviation.

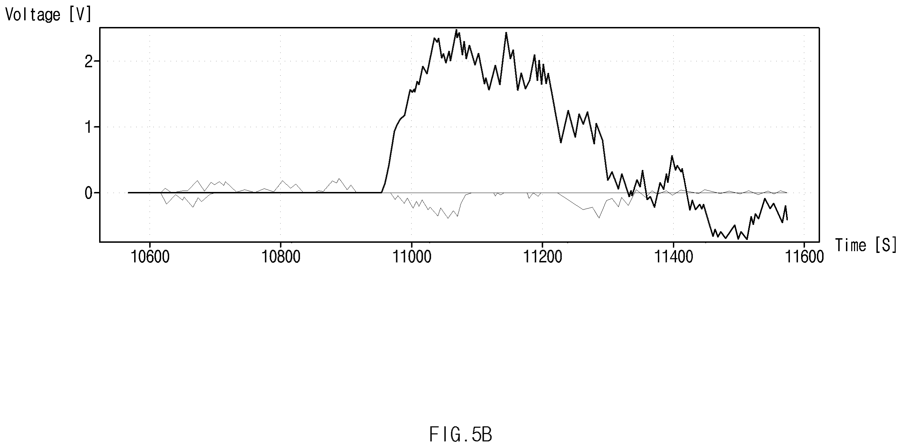

FIG. 5B is a graph showing the third diagnosis deviation D3 of a battery cell according to an embodiment disclosed herein.

Referring to FIG. 5B, the controller 220 may calculate the third diagnosis deviation D3 of each of the plurality of battery cells 110, 120, 130, and 140 by normalizing the second diagnosis deviation D2 of each of the plurality of battery cells 110, 120, 130, and 140, according to various embodiments.

The controller 220 may continuously calculate the third diagnosis deviation D3 of each of the plurality of battery cells 110, 120, 130, and 140 for each unit time to generate a graph indicating a change in the third diagnosis deviation D3 of each of the plurality of battery cells 110, 120, 130, and 140.

For example, the controller 220 may normalize the second diagnosis deviation D2 of each of the plurality of battery cells 110, 120, 130, and 140 by using the second deviation V_avg_LMA - V_avg_SMA indicating a behavior of the average voltage V_avg of the plurality of battery cells 110, 120, 130, and 140.

Referring back to FIG. 4, in operation S106, the controller 220 may calculate a skewness of the third diagnosis deviation D3 of each of the plurality of battery cells 110, 120, 130, and 140. In operation S106, specifically, the controller 220 may calculate the skewness of the third diagnosis deviation D3 of each of the plurality of battery cells 110, 120, 130, and 140, based on Equation 4 below.

Skewness = (Third Diagnosis Deviation D3 + Min[Third Diagnosis Deviation D3])/Third Diagnosis Deviation D3 [Equation 4]

In operation S106, referring to Equation 4, the controller 220 may calculate a skewness of each of the plurality of battery cells 110, 120, 130, and 140 by dividing a value, obtained by adding a minimum value (Min[Third Diagnosis Deviation D3]) of the third diagnosis deviation D3 of each of the plurality of battery cells 110, 120, 130, and 140 to the third diagnosis deviation D3 of each of the plurality of battery cells 110, 120, 130, and 140 , by the third diagnosis deviation D3.

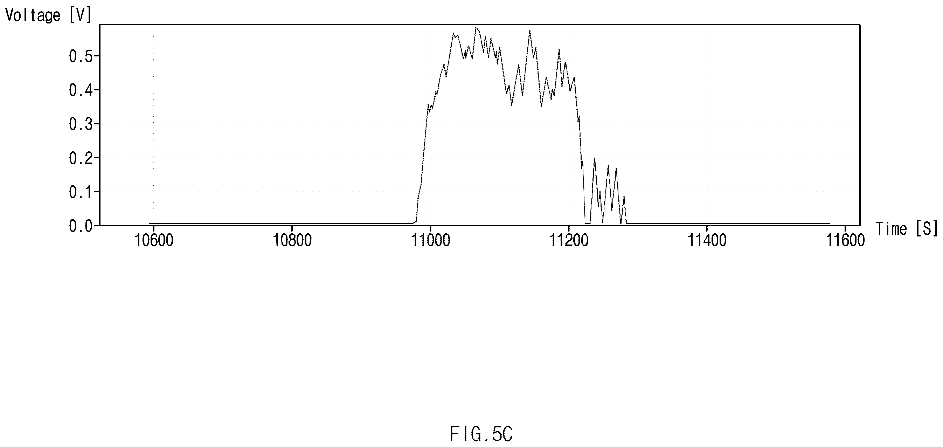

FIG. 5C is a graph showing a skewness of a third diagnosis deviation of a battery cell according to an embodiment disclosed herein.

Referring to FIG. 5C, the controller 220 may continuously calculate the skewness of the third diagnosis deviation D3 of each of the plurality of battery cells 110, 120, 130, and 140 for each unit time to generate a graph indicating a change in the skewness of the third diagnosis deviation D3 of each of the plurality of battery cells 110, 120, 130, and 140.

Referring back to FIG. 4, in operation S106, the controller 220 may calculate a fourth diagnosis deviation D4 of each of the plurality of battery cells 110, 120, 130, and 140 by reflecting the skewness to the third diagnosis deviation D3 of each of the plurality of battery cells 110, 120, 130, and 140. To be more specific, the controller 220 may calculate the fourth diagnosis deviation D4 of each of the plurality of battery cells 110, 120, 130, and 140, based on Equation 5.

[Equation 5]

$$\text{Fourth Diagnosis Deviation D4} = \text{Third Diagnosis Deviation D3} * \text{Skewness}$$

In operation S106, the controller 220 may calculate a fourth diagnosis deviation D4 of each of the plurality of battery cells 110, 120, 130, and 140 by multiplying the skewness to the third diagnosis deviation D3 of each of the plurality of battery cells 110, 120, 130, and 140.

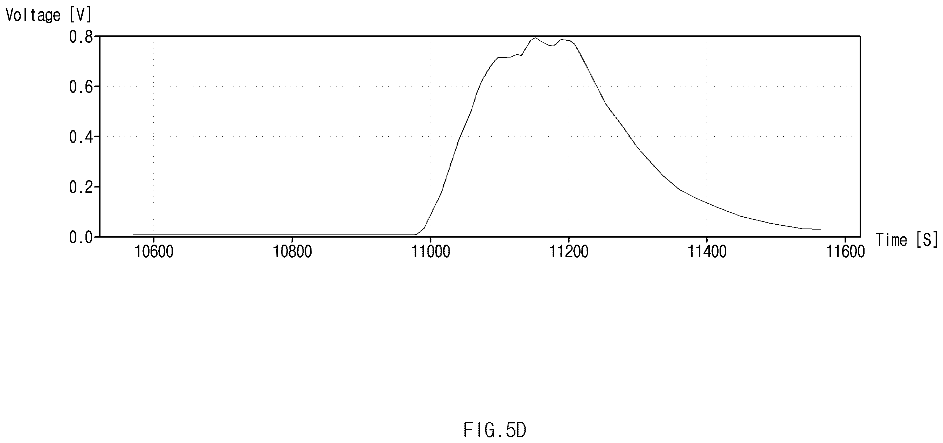

FIG. 5D is a graph showing a fourth diagnosis deviation of a battery cell according to an embodiment disclosed herein.

Referring to FIG. 5D, the controller 220 may continuously calculate the fourth diagnosis deviation D4 of each of the plurality of battery cells 110, 120, 130, and 140 for each unit time to generate a graph indicating a change in the fourth diagnosis deviation D4 of each of the plurality of battery cells 110, 120, 130, and 140.

The controller 220 may determine whether the fourth diagnosis deviation D4 of each of the plurality of battery cells 110, 120, 130, and 140 exceeds a threshold. The controller 220 may determine a battery cell as being suspected to have an abnormal behavior of a voltage when the fourth diagnosis deviation D4 of the battery cell among the plurality of battery cells 110, 120, 130, and 140 exceeds the threshold.

The controller 220 may calculate an accumulative deviation by accumulating the first diagnosis deviation D1 of the battery cell having the fourth diagnosis deviation D4 exceeding the threshold among the plurality of battery cells 110, 120, 130, and 140. The controller 220 may classify the battery cell as an abnormal battery cell or a noise battery cell based on the accumulative deviation of the battery cell having the fourth diagnosis deviation D4 exceeding the threshold among the plurality of battery cells 110, 120, 130, and 140.

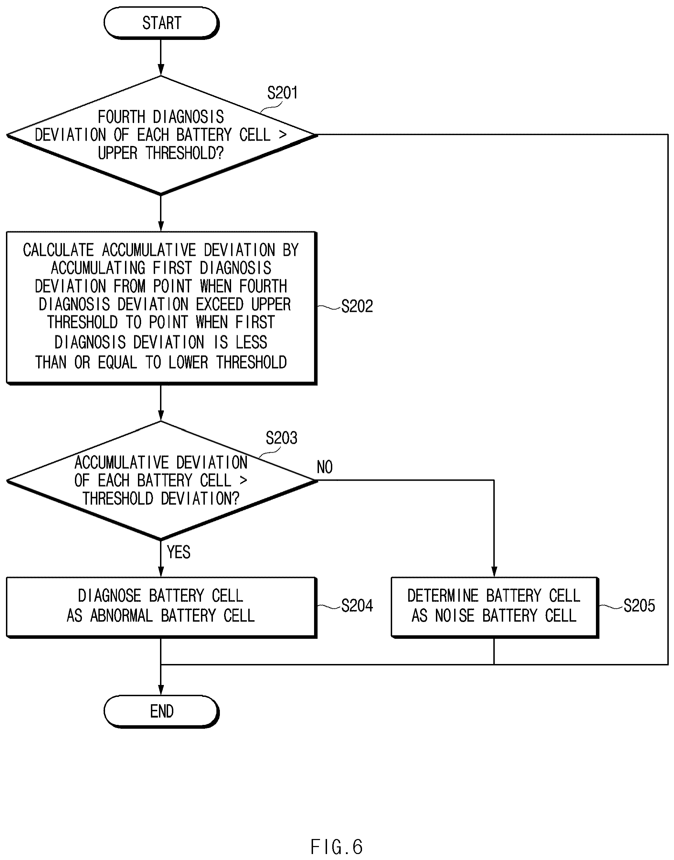

FIG. 6 is a flowchart illustrating a method of diagnosing an abnormal battery cell by a controller, according to an embodiment disclosed herein.

Hereinbelow, a method of diagnosing the abnormal battery cell by the controller will be described in detail with reference to FIG. 6.

In operation S201, the controller 220 may determine whether the fourth diagnosis deviation D4 of each of the plurality of battery cells 110, 120, 130, and 140 exceeds an upper threshold (UT). Herein, the UT may be defined as a criterion for determining 'abnormality' because an extreme result is output. That is, the UT may be defined as a criterion indicating a degree to which data contradicts a particular statistical model. In operation S201, the controller 220 may determine battery cells suspected as abnormal battery cells due to an abnormal voltage behavior among the plurality of battery cells 110, 120, 130, and 140, by determining whether the fourth diagnosis deviation D4 of each of the plurality of battery cells 110, 120, 130, and 140 exceeds the UT.

In operation S202, the controller 220 may determine a battery cell as having an abnormal behavior of a voltage when the fourth diagnosis deviation D4 of the battery cell among the plurality of battery cells 110, 120, 130, and 140 exceeds the UT. Specifically, the controller 220 may continuously calculate a first diagnosis deviation D1 of each of the plurality of battery cells 110, 120, 130, and 140 by calculating the first diagnosis deviation D1 of each of the plurality of battery cells 110, 120, 130, and 140 for each unit time.

In operation S202, the controller 220 may calculate an accumulative deviation of each of the plurality of battery cells 110, 120, 130, and 140 based on [Equation 6].

[Equation 6]

$$\text{Accumulative Deviation} = \sum_{t=a}^{t=b} \text{First Diagnosis Deviation } D1$$

Referring to [Equation 6], for a battery cell having the fourth diagnosis deviation D4 exceeding the UT among the plurality of battery cells 110, 120, 130, and 140, the controller 220 may calculate an accumulative deviation by accumulating the first diagnosis deviation D1 from a time ($t = a$) at which the fourth diagnosis deviation D4 of the battery cell exceeds the UT to a time ($t = b$) at which the first diagnosis deviation D1 of the battery cell is less than a lower threshold (LT).

Herein, the LT of the first diagnosis deviation D1 may include, for example, '0 V'. That is, the controller 220 may calculate the accumulative deviation of the battery cell by accumulating the first diagnosis deviation D1 from the time ($t = a$) at which the fourth diagnosis deviation D4 of the battery cell exceeds the UT to the time ($t = b$) at which the first diagnosis deviation D1 equals to '0'.

In operation S203, the controller 220 may determine whether the accumulative deviation of each of the plurality of battery cells 110, 120, 130, and 140 exceeds a threshold deviation. In operation S203, the controller 220 may diagnose at least one of the plurality of battery cells 110, 120, 130, and 140 as an abnormal battery cell or determine the same as a noise battery cell, based on whether the accumulative deviation of each of the plurality of battery cells 110, 120, 130, and 140 exceeds the threshold deviation.

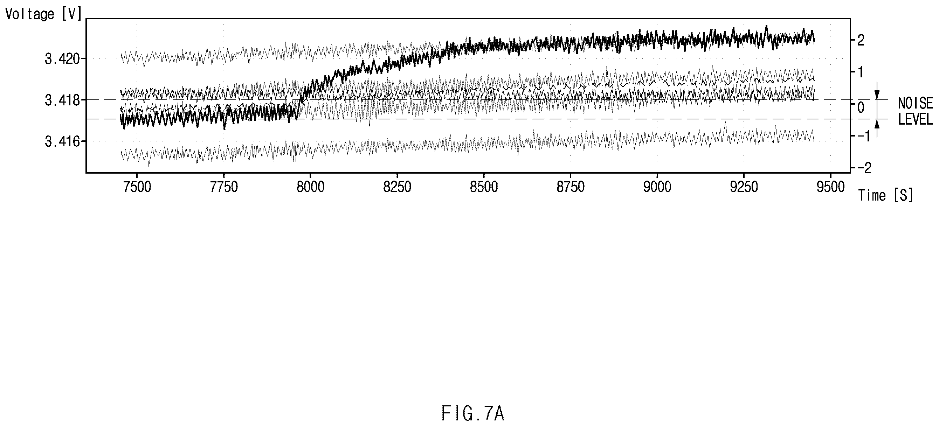

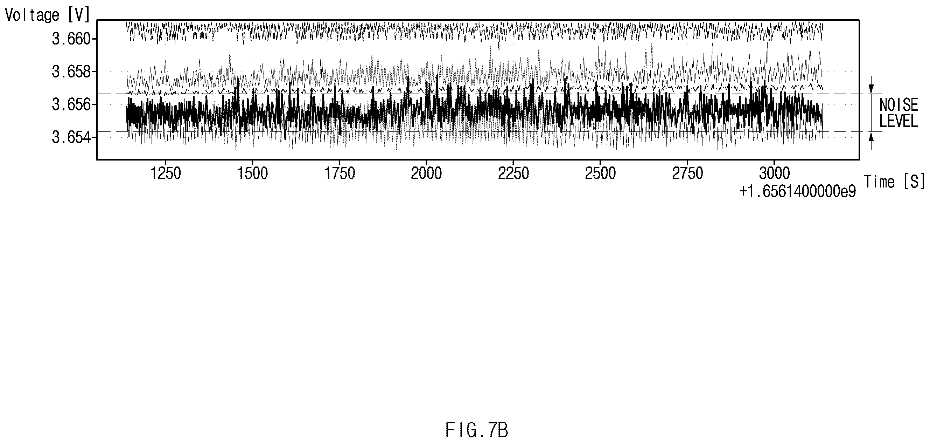

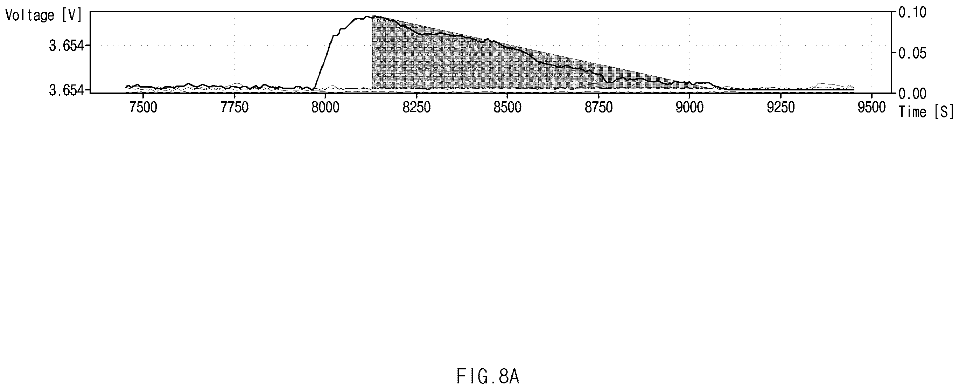

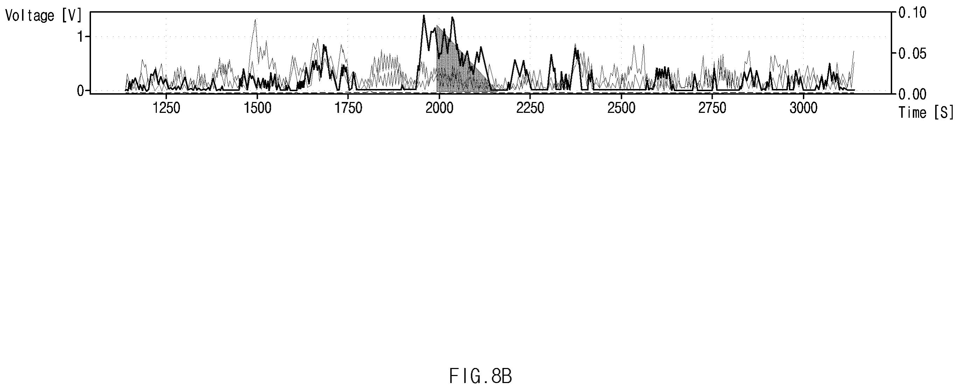

FIG. 7A is a graph showing a voltage of an abnormal battery cell according to an embodiment disclosed herein. FIG. 7B is a graph showing a voltage of an abnormal battery cell according to an embodiment disclosed herein. FIG. 8A is a graph showing a first diagnosis deviation of an abnormal battery cell according to an embodiment disclosed herein. FIG. 8B is a graph showing a first diagnosis deviation of a noise battery cell according to an embodiment disclosed herein.

Referring to FIGS. 7A to 8B, a noise battery cell having a great measured noise value may have a less accumulative value than the abnormal battery cell. Thus, the controller 220 may identify the battery cell as an abnormal battery cell or a noise battery cell based on a threshold deviation that is a reference value for diagnosing the battery cell as the abnormal battery cell or determining the battery cell as the noise battery cell.

Referring back to FIG. 6, in operation S204, when the accumulative deviation of at least one of the plurality of battery cells 110, 120, 130, and 140 exceeds the threshold deviation, the controller 220 may diagnose the battery cell as the abnormal battery cell.

In operation S205, when the accumulative deviation of at least one of the plurality of battery cells 110, 120, 130, and 140 is less than or equal to the threshold deviation, the controller 220 may diagnose the battery cell as the noise battery cell.

After diagnosing the at least one of the plurality of battery cells 110, 120, 130, and 140, the controller 220 may track and monitor whether a defect of the battery cell, such as internal short-circuit, external short-circuit, lithium precipitation, etc., occurs.

When the controller 220 determines that a defect occurs in the battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

As described above, the battery management apparatus 200 according to an embodiment disclosed herein may accurately diagnose an abnormal battery cell by using an accumulative deviation between a long moving average and a short moving average of a voltage of a battery cell.

In a conventional battery management apparatus, an abnormal behavior signal of a voltage of each battery cell is distorted using a deviation of a voltage of each battery cell with respect to an average voltage of battery cells and there is a possibility of misdiagnosis due to noise data, but the battery management apparatus 200 according to an embodiment disclosed herein may minimize distortion of the voltage of the battery cell by using the deviation of the long moving average and the short moving average of the voltage of each battery cell, remove noise data, and amplify the voltage behavior of the abnormal battery cell by applying the skewness of the voltage of the battery cell, thereby improving the accuracy of diagnosis. By using an accumulative value of voltage deviation data of a battery cell suspected to have an abnormal voltage behavior, the battery management apparatus 200 may diagnose the battery cell as the abnormal battery cell or determine the battery cell as the noise battery cell.

The battery management apparatus 200 may early diagnose the battery cell having the abnormal voltage behavior occurring by using the deviation of the long moving average and the short moving average of the voltage of the battery cell, thereby securing safety and reliability of the battery energy. In addition, the battery management apparatus 200 may diagnose quickly and conveniently the battery cell because of no need to remove the battery cell having the abnormal voltage behavior occurring in the state of the battery being mounted on a vehicle.

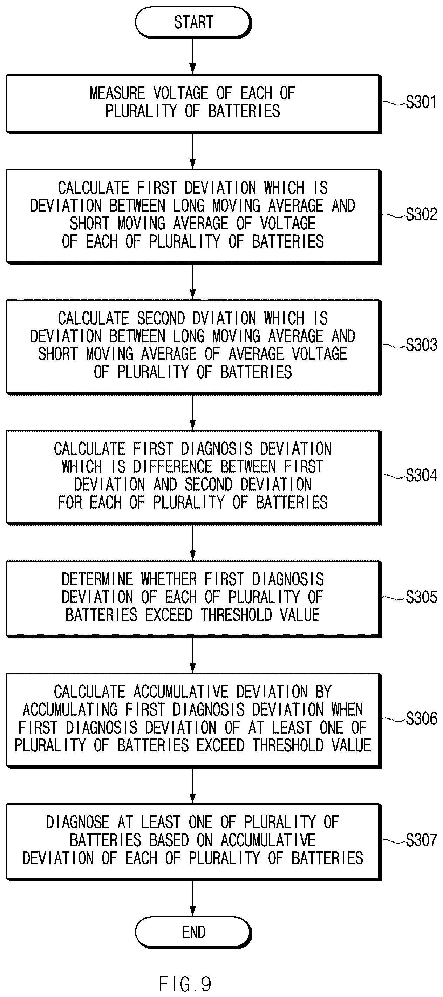

FIG. 9 is a flowchart of an operating method of a battery management apparatus according to an embodiment disclosed herein.

Hereinbelow, an operating method of the battery management apparatus 200 will be described with reference to FIGS. 1 and 8B.

The battery management apparatus 200 may be substantially the same as the battery management apparatus 200 described with reference to FIGS. 1 to 8B, and thus will be briefly described to avoid redundant description.

Referring to FIG. 9, the operating method of the battery management apparatus may include operation S301 of measuring a voltage of each of the plurality of batteries 110, 120, 130, and 140, operation S302 of calculating a plurality of first deviations that are deviations of a long moving average and a short moving average of each of the plurality of batteries 110, 120, 130, and 140, operation S303 of calculating a second deviation that is a deviation between a long moving average and a short moving average of an average of the plurality of batteries 110, 120, 130, and 140, operation S340 of calculating a first diagnosis deviation of each of the plurality of batteries 110, 120, 130, and 140, which is a deviation between a first deviation and a second deviation of each of the plurality of batteries, operation S305 of determining whether a first diagnosis deviation of each of the plurality of batteries 110, 120, 130, and 140 exceeds a threshold, operation S306 of calculating an accumulative deviation by accumulating the first diagnosis deviation when the first diagnosis deviation of at least one of the plurality of batteries 110, 120, 130, and 140 exceeds a threshold, and operation S307 of diagnosing at least one of the plurality of batteries 110, 120, 130, and 140 based on the accumulative deviation of each of the plurality of batteries 110, 120, 130, and 140.

Hereinbelow, operations S301 through S307 will be described in detail.

In operation S301, the voltage measurement unit 210 may calculate the voltage of each of the plurality of battery cells 110, 120, 130, and 140. The voltage measurement unit 210 may calculate the voltage of each of the plurality of battery cells 110, 120, 130, and 140 for each unit time to calculate time-series data of the voltage of each of the plurality of battery cells 110, 120, 130, and 140. In operation S301, according to an embodiment, the voltage measurement unit 210 may continuously calculate voltage rise and drop and long-term relaxation data of the plurality of battery cells 110, 120, 130, and 140 in charging, an idle period after charging, discharging, and an idle period after discharging.

In operation S301, the voltage measurement unit 210 may calculate the time-series data of the voltage of each of the plurality of battery cells 110, 120, 130, and 140 by measuring the voltages of the plurality of battery cells 110, 120, 130, and 140 in charging, an idle period after charging, discharging, and an idle period after discharging. In operation S301, the voltage measurement unit 210 may generate a graph indicating a voltage change of each of the plurality of battery cells 110, 120, 130, and 140 by measuring the voltage of each of the plurality of battery cells 110, 120, 130, and 140 for each unit time.

In operation S302, the controller 220 may calculate a moving average of the voltage of each of the plurality of battery cells 110, 120, 130, and 140. Herein, the moving average may be an average of some data extracted during movement on a window of a certain size among the entire data.

In operation S302, the controller 220 may calculate the moving average of the voltage of each of the plurality of battery cells 110, 120, 130, and 140 by using voltage data extracted during movement in the window from among the entire voltage data of each of the plurality of battery cells 110, 120, 130, and 140. The controller 220 may calculate a continuous moving average of the voltage of each of the plurality of battery cells 110, 120, 130, and 140 by using voltage data continuously extracted during movement in the window from among the entire voltage data of each of the plurality of battery cells 110, 120, 130, and 140. In operation S302, for example, the controller 220 may calculate the moving average of the voltage of each of the plurality of battery cells 110, 120, 130, and 140 by applying any one of a simple moving average, a weighted moving average, or an exponential moving average (EMA) to the whole voltage data of each of the plurality of battery cells 110, 120, 130, and 140. In operation S302, according to an embodiment, the controller 220 may calculate the EMA of the voltage of each of the plurality of battery cells 110, 120, 130, and 140 by applying the EMA to the entire voltage data of each of the plurality of battery cells 110, 120, 130, and 140.

In operation S302, the controller 220 may calculate a plurality of moving averages having different window sizes by using the voltage data of each of the plurality of battery cells 110, 120, 130, and 140. In operation S302, according to an embodiment, the controller 220 may calculate a long moving average having a long window length and a short moving average having a short window length by using the entire voltage data of each of the plurality of battery cells 110, 120, 130, and 140.

In operation S302, the controller 220 may diagnose whether a voltage of each of the plurality of battery cells is abnormal, by using the long moving average V_LMA and the short moving average V_SMA of each of the plurality of battery cells 110, 120, 130, and 140.

In operation S302, the controller 220 may calculate first deviations V_LMA - V_SMA which are deviations of the long moving average V_LMA and the short moving average V_SMA of the voltage of each of the plurality of battery cells 110, 120, 130, and 140. In operation S302, the controller 220 may continuously calculate the first deviation V_LMA - V_SMA of each of the plurality of battery cells 110, 120, 130, and 140 calculated during a unit time. In operation S302, that is, the controller 220 may calculate a deviation between a long behavior and a short behavior of each of the plurality of battery cells 110, 120, 130, and 140.

In operation S303, the controller 220 may calculate a long moving average V_avg_LMA and a short moving average V_avg_SMA of an average voltage V_avg of the plurality of battery cells 110, 120, 130, and 140. Herein, the average voltage V_avg of the plurality of battery cells 110, 120, 130, and 140 may include a mean, a median, or a minimum value of the voltages of the plurality of battery cells 110, 120, 130, and 140.

In operation S303, the controller 220 may continuously calculate the average voltage V_avg of the plurality of battery cells 110, 120, 130, and 140 for each unit time, and calculate the long moving average V_avg_LMA and the short moving average V_avg_SMA of the average voltage V_avg of the plurality of battery cells 110, 120, 130, and 140 by using the average voltage V_avg of the plurality of battery cells 110, 120, 130, and 140. Herein, a window size of the long moving average V_avg_LMA of the average voltage V_avg of the plurality of battery cells 110, 120, 130, and 140 may equal a window size of the long moving average V_LMA of the voltage of each of the plurality of battery cells 110, 120, 130, and 140. Herein, a window size of the short moving average V_avg_SMA of the average voltage V_avg of the plurality of battery cells 110, 120, 130, and 140 may equal a window size of the short moving average V_SMA of the voltage of each of the plurality of battery cells 110, 120, 130, and 140.

In operation S303, the controller 220 may calculate a second deviation V_avg_LMA - V_avg_SMA that is a deviation between the long moving average V_avg_LMA and the short moving average V_avg_SMA of the average voltage V_avg of the plurality of battery cells 110, 120, 130, and 140. In operation S303, the controller 220 may continuously calculate the second deviation V_avg_LMA - V_avg_SMA of the plurality of battery cells 110, 120, 130, and 140 for each unit time.

In operation S304, the controller 220 may calculate a first diagnosis deviation D1 of each of the plurality of battery cells 110, 120, 130, and 140, which is a deviation of the plurality of first deviations V_LMA - L_SMA and the second deviation V_avg_LMA-V_avg_SMA.

In operation S304, specifically, the controller 220 may calculate the first diagnosis deviation D1 of each of the plurality of battery cells 110, 120, 130, and 140, based on Equation 7.

First Diagnosis Deviation (D1) = Second Deviation - First Deviation = (V_avg_LMA - V_avg_SMA) - (V_LMA - V_SMA)  [Equation 7]

Referring to Equation 7, the controller 220 may calculate the deviation of the plurality of first deviations V_LMA - V_SMA and the second deviation V_avg_LMA - V_avg_SMA as the first diagnosis deviation D1 of each of the plurality of battery cells 110, 120, 130, and 140.

In operation S304, the controller 220 may continuously calculate the first diagnosis deviation D1 of each of the plurality of battery cells 110, 120, 130, and 140 for each unit time to generate a graph indicating a change in the first diagnosis deviation D1 of each of the plurality of battery cells 110, 120, 130, and 140.

In operation S305, the controller 220 may determine whether the first diagnosis deviation D1 of each of the plurality of battery cells 110, 120, 130, and 140 exceeds a threshold.

In operation S306, when the first diagnosis deviation D1 of at least one of the plurality of battery cells 110, 120, 130, and 140 exceeds the threshold value, the controller 220 may calculate the accumulative deviation by accumulating the first diagnosis deviation D1.

In operation S307, the controller 220 may diagnose at least one of the plurality of battery cells 110, 120, 130, and 140 as an abnormal battery cell, based on an accumulative deviation of each of the plurality of battery cells 110, 120, 130, and 140.

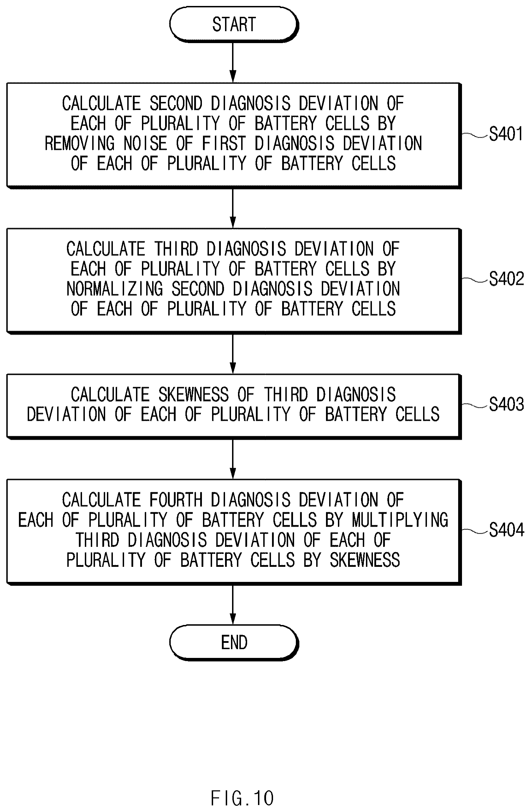

FIG. 10 is a flowchart illustrating a method of calculating a diagnosis deviation of a battery cell by a battery management apparatus, according to an embodiment disclosed herein.

Hereinbelow, a method, performed by the controller 220 of the battery management apparatus 200, of calculating a diagnosis deviation of each of the plurality of battery cells 110, 120, 130, and 140 will be described in detail with reference to FIG. 10.

In operation S401, the controller 220 may calculate a second diagnosis deviation D2 of each of the plurality of battery cells 110, 120, 130, and 140 by removing noise data from the first diagnosis deviation D1 of each of the plurality of battery cells 110, 120, 130, and 140.

In operation S401, specifically, the controller 220 may set a reference value for determining noise of the first diagnosis deviation D1 of each of the plurality of battery cells 110, 120, 130, and 140, based on Equation 8.

$$[\text{Equation 8}]$$

$$\text{Reference Value} = \text{Max}[|V\_avg\_LMA - V\_avg\_SMA| * C1, C2]$$

In operation S401, the controller 220 may set a maximum value Max between a value ($|V\_avg\_LMA - V\_avg\_SMA|*C1$) obtained by multiplying an absolute value of the second deviation ($V\_avg\_LMA - V\_avg\_SMA$) by a first threshold constant C1 and a second threshold constant C2 as a reference value for each of the plurality of battery cells 110, 120, 130, and 140.

In operation S401, the controller 220 may determine the first diagnosis deviation D1 less than or equal to the reference value among the first diagnosis deviation D1 of each of the plurality of battery cells 110, 120, 130, and 140 as noise data. In operation S401, the controller 220 may calculate the second diagnosis deviation D2 of each of the plurality of battery cells 110, 120, 130, and 140 by excluding the first diagnosis deviation D1 less than or equal to the reference value among the first diagnosis deviation D1 of each of the plurality of battery cells 110, 120, 130, and 140.

In operation S306, the controller 220 may diagnose at least one of the plurality of battery cells 110, 120, 130, and 140, by using the second diagnosis deviation D2 of each of the plurality of battery cells 110, 120, 130, and 140.

Referring to FIG. 7, the operating method of the battery management apparatus may include operation S401 of calculating a third diagnosis deviation of each of the plurality of batteries 110, 120, 130, and 140 by normalizing a second diagnosis deviation of each of the plurality of batteries 110, 120, 130, and 140, operation S402 of calculating a skewness of the third diagnosis deviation of each of the plurality of batteries 110, 120, 130, and 140, operation S403 of calculating a fourth diagnosis deviation of each of the plurality of batteries 110, 120, 130, and 140 by multiplying the third diagnosis deviation of each of the plurality of batteries 110, 120, 130, and 140 by the skewness, and operation S404 of diagnosing a battery by determining whether the fourth diagnosis deviation of each of the plurality of batteries 110, 120, 130, and 140 exceeds a threshold value.

Hereinbelow, operations S401 through S404 will be described in detail.

In operation S402, the controller 220 may calculate a third diagnosis deviation D3 by normalizing the second diagnosis deviation D2 of each of the plurality of battery cells 110, 120, 130, and 140. In operation S401, specifically, the controller 220 may calculate the third diagnosis deviation D3 of each of the plurality of battery cells 110, 120, 130, and 140 by normalizing the second diagnosis deviation D2 of each of the plurality of battery cells 110, 120, 130, and 140, based on Equation 9 below.

$$\text{Third Diagnosis Deviation} = \text{Second Diagnosis Deviation} / \text{Max}[|V\_avg\_LMA - V\_avg\_SMA| * C3, C4] \qquad [\text{Equation 9}]$$

In operation S402, the controller 220 may calculate a maximum value Max between a value $|V\_avg\_LMA - V\_avg\_SMA|*C3$ obtained by multiplying the absolute value $|V\_avg\_LMA - V\_avg\_SMA|$ of the second deviation by the third threshold constant C3 and a fourth threshold constant C4. The controller 220 may normalize the second diagnosis deviation D2 of each of the plurality of battery cells 110, 120, 130, and 140 by using the maximum value $\text{Max}[|V\_avg\_LMA - V\_avg\_SMA|*C3,C4]$ between the value obtained by multiplying the absolute value of the second deviation by the third threshold constant and the fourth threshold constant C4. Herein, the third threshold constant C3 may include '0.1', and the fourth threshold constant C4 may include '0.1', and the third threshold constant C3 and the fourth threshold constant C4 may change according to a size and characteristics of voltage data of each of the plurality of battery cells 110, 120, 130, and 140. In operation S402, the controller 220 may calculate, as the third diagnosis deviation D3 of each of the plurality of battery cells 110, 120, 130, and 140, a value obtained by normalizing the second diagnosis deviation D2 of each of the plurality of battery cells 110, 120, 130, and 140 by using the second deviation $V\_avg\_LMA - V\_avg\_SMA$ indicating a behavior of the average voltage $V\_avg$ of the plurality of battery cells 110, 120, 130, and 140.

In operation S402, according to an embodiment, the controller 220 may normalize the second diagnosis deviation D2 of each of the plurality of battery cells 110, 120, 130, and 140 through a log operation. That is, the controller 220 may calculate, as the third diagnosis deviation D3 of each of the plurality of battery cells 110, 120, 130, and 140, a value obtained by normalizing the second diagnosis deviation D2 of each of the plurality of battery cells 110, 120, 130, and 140 through a log operation.

In operation S402, according to an embodiment, the controller 220 may set, as a normalization reference value, an average D2_avg of the second diagnosis deviation D2 of each of the plurality of battery cells 110, 120, 130, and 140. In operation S402, the controller 220 may perform normalization by dividing the second diagnosis deviation D2 of each of the plurality of battery cells 110, 120, 130, and 140 by the average value D2_avg of the second diagnosis deviation D2, by using the average D2_avg of the second diagnosis deviation as a normalization reference value. That is, the controller 220 may calculate, as the third diagnosis deviation D3 of each of the plurality of battery cells 110, 120, 130, and 140, a value obtained through normalization by dividing the second diagnosis deviation D2 of each of the plurality of battery cells 110, 120, 130, and 140 by the average D2_avg of the second diagnosis deviation. In operation S402, the controller 220 may calculate the third diagnosis deviation D3 of each of the plurality of battery cells 110, 120, 130, and 140 by normalizing the second diagnosis deviation D2 of each of the plurality of battery cells 110, 120, 130, and 140, according to various embodiments.

In operation S403, the controller 220 may continuously calculate the third diagnosis deviation D3 of each of the plurality of battery cells 110, 120, 130, and 140 for each unit time to generate a graph indicating a change in the third diagnosis deviation D3 of each of the plurality of battery cells 110, 120, 130, and 140. In operation S403, the controller 220 may calculate a skewness of the third diagnosis deviation D3 of each of the plurality of battery cells 110, 120, 130, and 140. In operation S403, specifically, the controller 220 may calculate the skewness of the third diagnosis deviation D3 of each of the plurality of battery cells 110, 120, 130, and 140, based on Equation 10 below.

Skewness = (Third Diagnosis Deviation D3 + Min[Third Diagnosis Deviation D3])/Third Diagnosis Deviation D3 [Equation 10]

In operation S403, referring to Equation 10, the controller 220 may calculate a skewness of each of the plurality of battery cells 110, 120, 130, and 140 by dividing a value, obtained by adding a minimum value (Min[Third Diagnosis Deviation D3]) of the third diagnosis deviation D3 of each of the plurality of battery cells 110, 120, 130, and 140 to the third diagnosis deviation D3 of each of the plurality of battery cells 110, 120, 130, and 140 , by the third diagnosis deviation D3.

In operation S403, the controller 220 may continuously calculate a skewness of the third diagnosis deviation D3 of each of the plurality of battery cells 110, 120, 130, and 140 for each unit time to generate a graph indicating a change in the skewness of the third diagnosis deviation D3 of each of the plurality of battery cells 110, 120, 130, and 140.

In operation S404, the controller 220 may calculate the fourth diagnosis deviation D4 by applying the skewness to the third diagnosis deviation D3 of each of the plurality of battery cells 110, 120, 130, and 140. In operation S404, specifically, the controller 220 may calculate the fourth diagnosis deviation D4 of each of the plurality of battery cells 110, 120, 130, and 140, based on Equation 11.

[Equation 11]

Fourth Diagnosis Deviation D4 = Third Diagnosis Deviation D3 * Skewness

In operation S404, the controller 220 may calculate a fourth diagnosis deviation D4 of each of the plurality of battery cells 110, 120, 130, and 140 by multiplying the skewness to the third diagnosis deviation D3 of each of the plurality of battery cells 110, 120, 130, and 140. In operation S404, the controller 220 may continuously calculate the fourth diagnosis deviation D4 of each of the plurality of battery cells 110, 120, 130, and 140 for each unit time to generate a graph indicating a change in the fourth diagnosis deviation D4 of each of the plurality of battery cells 110, 120, 130, and 140.

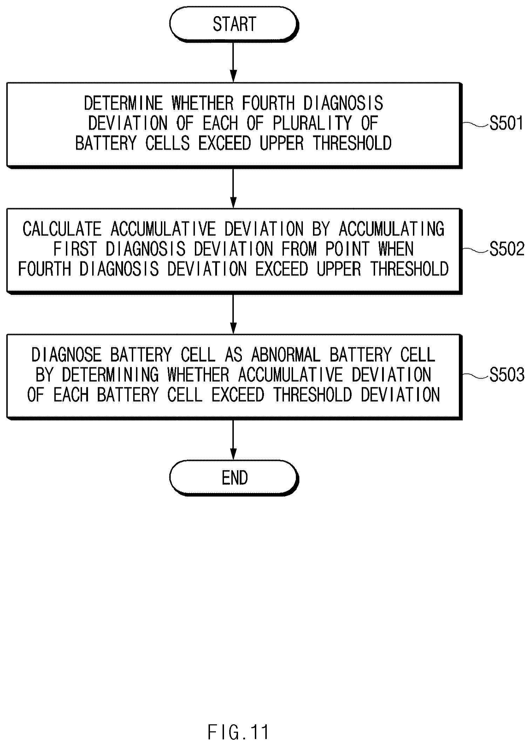

FIG. 11 is a flowchart illustrating a method of diagnosing an abnormal battery cell by a battery management apparatus, according to an embodiment disclosed herein.

Hereinbelow, a method, performed by the controller 220 of the battery management apparatus 200, of diagnosing an abnormal battery cell by using a diagnosis deviation of each of the plurality of battery cells 110, 120, 130, and 140 will be described in detail with reference to FIG. 11.

In operation S501, the controller 220 may determine whether the fourth diagnosis deviation D4 of each of the plurality of battery cells 110, 120, 130, and 140 exceeds an UT. Herein, the UT may be defined as a criterion for determining 'abnormality' because an extreme result is output. That is, the UT may be defined as a criterion indicating a degree to which data contradicts a particular statistical model. In operation S501, the controller 220 may determine battery cells suspected as abnormal battery cells due to an abnormal voltage behavior among the plurality of battery cells 110, 120, 130, and 140, by determining whether the fourth diagnosis deviation D4 of each of the plurality of battery cells 110, 120, 130, and 140 exceeds the UT.

In operation S502, the controller 220 may determine a battery cell as having an abnormal behavior of a voltage when the fourth diagnosis deviation D4 of the battery cell among the plurality of battery cells 110, 120, 130, and 140 exceeds the UT. Specifically, the controller 220 may continuously calculate a first diagnosis deviation D1 of each of the plurality of battery cells 110, 120, 130, and 140 by calculating the first diagnosis deviation D1 of each of the plurality of battery cells 110, 120, 130, and 140 for each unit time.

In operation S502, the controller 220 may calculate an accumulative deviation of each of the plurality of battery cells 110, 120, 130, and 140 based on [Equation 12].

[Equation 12]

$$\text{Accumulative Deviation} = \sum_{t=b}^{t=a} First\ Diagnosis\ Deviation\ D1$$

Referring to [Equation 12], for a battery cell having the fourth diagnosis deviation D4 exceeding the UT among the plurality of battery cells 110, 120, 130, and 140, the controller 220 may calculate an accumulative deviation by accumulating the first diagnosis deviation D1 from a time (t = a) at which the fourth diagnosis deviation D4 of the battery cell exceeds the UT to a time (t = b) at which the first diagnosis deviation D1 of the battery cell is less than a lower threshold (LT). Herein, the LT of the first diagnosis deviation D1 may include, for example, '0 V'. That is, the controller 220 may calculate the accumulative deviation of the battery cell by accumulating the first diagnosis deviation D1 from the time (t = a) at which the fourth diagnosis deviation D4 of the battery cell exceeds the UT to the time (t = b) at which the first diagnosis deviation D1 equals to '0'.

In operation S503, the controller 220 may determine whether the accumulative deviation of each of the plurality of battery cells 110, 120, 130, and 140 exceeds a threshold deviation. In operation S503, the controller 220 may diagnose at least one of the plurality of battery cells 110, 120, 130, and 140 as an abnormal battery cell or determine the same as a noise battery cell, based on whether the accumulative deviation of each of the plurality of battery cells 110, 120, 130, and 140 exceeds the threshold deviation.

A noise battery cell may have a less accumulative value than the abnormal battery cell. Thus, the controller 220 may identify the battery cell as an abnormal battery cell or a noise battery cell based on a threshold deviation that is a reference value for diagnosing the battery cell as the abnormal battery cell or determining the battery cell as the noise battery cell.

In operation S503, when the accumulative deviation of at least one of the plurality of battery cells 110, 120, 130, and 140 exceeds the threshold deviation, the controller 220 may diagnose the battery cell as the abnormal battery cell.

In operation S503, when the accumulative deviation of at least one of the plurality of battery cells 110, 120, 130, and 140 is less than or equal to the threshold deviation, the controller 220 may diagnose the battery cell as the noise battery cell.

In operation S503, after diagnosing the at least one of the plurality of battery cells 110, 120, 130, and 140, the controller 220 may track and monitor whether a defect of the battery cell, such as internal short-circuit, external short-circuit, lithium precipitation, etc., occurs.

In operation S503, when the controller 220 determines that a defect occurs in the battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

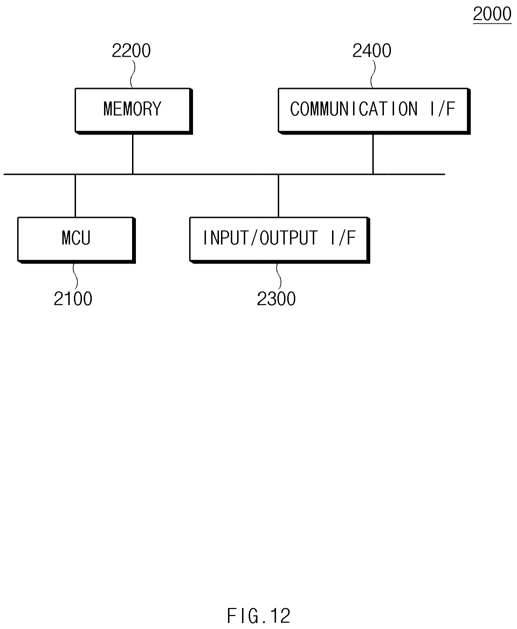

FIG. 12 is a block diagram showing a hardware configuration of a computing system for performing an operating method of a battery management apparatus, according to an embodiment disclosed herein.

Referring to FIG. 12, a computing system 2000 according to an embodiment disclosed herein may include a microcontroller unit (MCU) 2100, a memory 2200, an input/output interface (I/F) 2300, and a communication I/F 2400.

The MCU 2100 may be a processor that executes various programs (e.g., a battery voltage deviation analysis program, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

[Description of Symbols]

1000: Battery Pack
100: Battery Module
110: First Battery Cell
120: Second Battery Cell
130: Third Battery Cell
140: Fourth Battery Cell
200: Battery Management Apparatus
210: Voltage Measuring Unit
220: Controller
300: Relay
2000: Computing System
2100: MCU
2200: Memory
2300: Input/Output I/F
2400: Communication I/F

Claims

1. A battery management apparatus comprising:

a voltage measurement unit configured to measure a voltage of each of a plurality of batteries; and
a controller configured to:

calculate a first deviation, which is a deviation between a long moving average and a short moving average of a battery voltage for each of the plurality of batteries, calculate a second deviation, which is a deviation between a long moving average and a short moving average of an average voltage of the plurality of battery cells, and calculate a first diagnosis deviation between the first deviation and the second deviation for each of the plurality of battery cells;
calculate an accumulative deviation by accumulating the first diagnosis deviation when the first diagnosis deviation of at least one of the plurality of batteries exceeds a threshold value; and
diagnose at least one of the plurality of batteries as an abnormal battery, based on the accumulative deviation.

2. The battery management apparatus of claim 1, wherein the controller is further configured to:

set, as a reference value, a maximum value between a value, obtained by multiplying the second deviation by a first threshold constant, and a second threshold constant; and
calculate a second diagnosis deviation of each of the plurality of batteries by excluding a first diagnosis deviation less than or equal to the reference value among first diagnosis deviations of the plurality of batteries.

3. The battery management apparatus of claim 2, wherein the controller is further configured to perform normalization by dividing the second diagnosis deviation of each of the plurality of batteries by a maximum value between a value, obtained by multiplying the second deviation by a third threshold constant, and a fourth threshold constant to calculate a third diagnosis deviation of each of the plurality of batteries.

4. The battery management apparatus of claim 3, wherein the controller is further configured to calculate a skewness of each of the plurality of batteries by dividing a value, obtained by adding a minimum value of the third diagnosis deviation to the third diagnosis deviation of each of the plurality of batteries, by the third diagnosis deviation.

5. The battery management apparatus of claim 4, wherein the controller is further configured to calculate a fourth diagnosis deviation of each of the plurality of batteries by multiplying the third diagnosis deviation of each of the plurality of batteries by the skewness.

6. The battery management apparatus of claim 5, wherein the controller is further configured to, when a fourth diagnosis deviation of at least one of the plurality of batteries exceeds an upper threshold, calculate the accumulative deviation by accumulating a first diagnosis deviation of the at least one battery.

7. The battery management apparatus of claim 6, wherein the controller is further configured to calculate the accumulative deviation by accumulating the first diagnosis deviation of the at least one battery from a point when the fourth diagnosis deviation of the at least one of the plurality of batteries exceeds the upper threshold to a point when the first diagnosis deviation is less than or equal to a lower threshold.

8. The battery management apparatus of claim 7, wherein the controller is further configured to, when an accumulative deviation of at least one of the plurality of batteries exceeds a threshold deviation, diagnose the at least one battery as an abnormal battery.

9. The battery management apparatus of claim 7, wherein the controller is further configured to, when the accumulative deviation of the at least one of the plurality of batteries is less than or equal to the threshold deviation, diagnose the at least one battery as a noise battery.

10. An operating method of a battery management apparatus, the operating method comprising:

    measuring a voltage of each of a plurality of batteries;
    calculating a first deviation, which is a deviation between a long moving average and a short moving average of a battery voltage for each of the plurality of batteries;
    calculating a second deviation, which is a deviation between a long moving average and a short moving average of an average voltage of the plurality of battery cells;
    calculating a first diagnosis deviation between the first deviation and the second deviation for each of the plurality of battery cells;
    determining whether the first diagnosis deviation of each of the plurality of batteries exceeds a threshold value;
    calculating an accumulative deviation by accumulating the first diagnosis deviation when the first diagnosis deviation of at least one of the plurality of batteries exceeds a threshold value; and
    diagnosing at least one of the plurality of batteries as an abnormal battery, based on the accumulative deviation.

11. The operating method of claim 10, wherein the calculating of the first diagnosis deviation between the first deviation and the second deviation for each of the plurality of battery cells comprises:

    setting, as a reference value, a maximum value between a value, obtained by multiplying the second deviation by a first threshold constant, and a second threshold constant; and
    calculating a second diagnosis deviation of each of the plurality of batteries by excluding a first diagnosis deviation less than or equal to the reference value among first diagnosis deviations of the plurality of batteries.

12. The operating method of claim 11, wherein the calculating of the first diagnosis deviation between the first deviation and the second deviation for each of the plurality of battery cells comprises performing normalization by dividing the second diagnosis deviation of each of the plurality of batteries by a maximum value between a value, obtained by multiplying the second deviation by a third threshold constant, and a fourth threshold constant to calculate a third diagnosis deviation of each of the plurality of batteries.

13. The operating method of claim 12, wherein the calculating of the first diagnosis deviation between the first deviation and the second deviation for each of the plurality of battery cells comprises calculating a skewness of each of the plurality of batteries by dividing a value, obtained by adding a minimum value of the third diagnosis deviation to the third diagnosis deviation of each of the plurality of batteries, by the third diagnosis deviation.

14. The operating method of claim 13, wherein the calculating of the first diagnosis deviation between the first deviation and the second deviation for each of the plurality of battery cells comprises calculating a fourth diagnosis deviation of each of the plurality of batteries by multiplying the third diagnosis deviation of each of the plurality of batteries by the skewness.

15. The operating method of claim 14, wherein the calculating of the accumulative deviation by accumulating the first diagnosis deviation when the first diagnosis deviation of at least one of the plurality of batteries exceeds the threshold value comprises, when a fourth diagnosis deviation of at least one of the plurality of batteries exceeds an upper threshold, calculating the accumulative deviation by accumulating the first diagnosis deviation of the at least one battery.

16. The operating method of claim 15, wherein the calculating of the accumulative deviation by accumulating the first diagnosis deviation when the first diagnosis deviation of at least one of the plurality of batteries exceeds the threshold value comprises calculating the accumulative deviation by accumulating the first diagnosis deviation of the at least one battery from a point when the fourth diagnosis deviation of the at least one of the plurality of batteries exceeds the upper threshold to a point when the first diagnosis deviation is less than or equal to a lower threshold.

17. The operating method of claim 16, wherein the diagnosing of the at least one of the plurality of batteries as the abnormal battery, based on the accumulative deviation, comprises, when an accumulative deviation of at least one of the plurality of batteries exceeds a threshold deviation, diagnosing the at least one battery as an abnormal battery.

18. The operating method of claim 16, wherein the diagnosing of the at least one of the plurality of batteries as the abnormal battery, based on the accumulative deviation, comprises, when the accumulative deviation of at least one of the plurality of batteries is less than or equal to the threshold deviation, diagnosing the at least one battery as a noise battery.

300

1000

100

110

120

130

140

BATTERY
MANAGEMENT APPARATUS
200

FIG.1

200

| VOLTAGE MEASUREMENT UNIT 210 |———| CONTROLLER 220 |

FIG.2

F I G. 3

START

CALCULATE FIRST DEVIATION WHICH IS DEVIATION BETWEEN LONG MOVING AVERAGE AND SHORT MOVING AVERAGE OF VOLTAGE OF EACH OF PLURALITY OF BATTERY CELLS ——S101

CALCULATE SECOND DVIATION WHICH IS DEVIATION BETWEEN LONG MOVING AVERAGE AND SHORT MOVING AVERAGE OF AVERAGE VOLTAGE OF PLURALITY OF BATTERY CELLS ——S102

CALCULATE FIRST DIAGNOSIS DEVIATION WHICH IS DIFFERENCE BETWEEN FIRST DEVIATION AND SECOND DEVIATION FOR EACH OF PLURALITY OF BATTERY CELLS ——S103

CALCULATE SECOND DIAGNOSIS DEVIATION OF EACH OF PLURALITY OF BATTERY CELLS BY REMOVING NOISE OF FIRST DIAGNOSIS DEVIATION OF EACH OF PLURALITY OF BATTERY CELLS ——S104

CALCULATE THIRD DIAGNOSIS DEVIATION OF EACH OF PLURALITY OF BATTERY CELLS BY NORMALIZING SECOND DIAGNOSIS DEVIATION OF EACH OF PLURALITY OF BATTERY CELLS ——S105

CALCULATE FOURTH DIAGNOSIS DEVIATION OF EACH OF PLURALITY OF BATTERY CELLS BY MULTIPLYING THIRD DIAGNOSIS DEVIATION OF EACH OF PLURALITY OF BATTERY CELLS BY SKEWNESS ——S106

END

FIG.4

FIG.5A

EP 4 707 833 A1

F I G . 5B

FIG.5C

EP 4 707 833 A1

FIG.5D

```
                    ┌──────────┐
                    │  START   │
                    └──────────┘
                          │
                          ▼
              ╱───────────────────────╲           S201
            ╱      FOURTH DIAGNOSIS      ╲
          ╱   DEVIATION OF EACH BATTERY CELL > ╲─────────────────┐
          ╲       UPPER THRESHOLD?     ╱                         │
            ╲                         ╱                          │
              ╲───────────────────╱                             │
                          │                                     │
                          ▼                                     │
          ┌─────────────────────────────────┐                  │
          │  CALCULATE ACCUMULATIVE DEVIATION BY │              │
          │   ACCUMULATING FIRST DIAGNOSIS    │                 │
          │  DEVIATION FROM POINT WHEN FOURTH │   S202           │
          │  DIAGNOSIS DEVIATION EXCEED UPPER │                  │
          │   THRESHOLD TO POINT WHEN FIRST   │                  │
          │    DIAGNOSIS DEVIATION IS LESS    │                  │
          │ THAN OR EQUAL TO LOWER THRESHOLD  │                  │
          └─────────────────────────────────┘                   │
                          │                                     │
                          ▼                                     │
              ╱───────────────────────╲    S203                 │
            ╱   ACCUMULATIVE DEVIATION   ╲         NO            │
          ╱     OF EACH BATTERY CELL >     ╲──────────────┐      │
          ╲      THRESHOLD DEVIATION?    ╱                │      │
            ╲                         ╱                   │      │
              ╲───────────────────╱                      │      │
                          │ YES                           ▼      │
                          ▼                                      │
          ┌───────────────────────┐       ┌───────────────────────┐
          │   DIAGNOSE BATTERY CELL │ S204  │  DETERMINE BATTERY CELL │ S205
          │  AS ABNORMAL BATTERY CELL │      │  AS NOISE BATTERY CELL  │
          └───────────────────────┘       └───────────────────────┘
                          │                            │
                          ▼                            │
                    ┌──────────┐                       │
                    │   END    │◄──────────────────────┘
                    └──────────┘
```

FIG.6

FIG.7A

EP 4 707 833 A1

FIG.7B

FIG.8A

EP 4 707 833 A1

FIG.8B

START

MEASURE VOLTAGE OF EACH OF
PLURALITY OF BATTERIES — S301

CALCULATE FIRST DEVIATION WHICH IS
DEVIATION BETWEEN LONG MOVING AVERAGE AND
SHORT MOVING AVERAGE OF VOLTAGE
OF EACH OF PLURALITY OF BATTERIES — S302

CALCULATE SECOND DVIATION WHICH IS
DEVIATION BETWEEN LONG MOVING AVERAGE AND
SHORT MOVING AVERAGE OF AVERAGE VOLTAGE
OF PLURALITY OF BATTERIES — S303

CALCULATE FIRST DIAGNOSIS DEVIATION
WHICH IS DIFFERENCE BETWEEN FIRST
DEVIATION AND SECOND DEVIATION
FOR EACH OF PLURALITY OF BATTERIES — S304

DETERMINE WHETHER FIRST DIAGNOSIS
DEVIATION OF EACH OF PLURALITY OF
BATTERIES EXCEED THRESHOLD VALUE — S305

CALCULATE ACCUMULATIVE DEVIATION BY
ACCUMULATING FIRST DIAGNOSIS DEVIATION WHEN
FIRST DIAGNOSIS DEVIATION OF AT LEAST ONE OF
PLURALITY OF BATTERIES EXCEED THRESHOLD VALUE — S306

DIAGNOSE AT LEAST ONE OF PLURALITY OF
BATTERIES BASED ON ACCUMULATIVE
DEVIATION OF EACH OF PLURALITY OF BATTERIES — S307

END

FIG.9

START

CALCULATE SECOND DIAGNOSIS DEVIATION OF EACH OF PLURALITY OF BATTERY CELLS BY REMOVING NOISE OF FIRST DIAGNOSIS DEVIATION OF EACH OF PLURALITY OF BATTERY CELLS ~S401

CALCULATE THIRD DIAGNOSIS DEVIATION OF EACH OF PLURALITY OF BATTERY CELLS BY NORMALIZING SECOND DIAGNOSIS DEVIATION OF EACH OF PLURALITY OF BATTERY CELLS ~S402

CALCULATE SKEWNESS OF THIRD DIAGNOSIS DEVIATION OF EACH OF PLURALITY OF BATTERY CELLS ~S403

CALCULATE FOURTH DIAGNOSIS DEVIATION OF EACH OF PLURALITY OF BATTERY CELLS BY MULTIPLYING THIRD DIAGNOSIS DEVIATION OF EACH OF PLURALITY OF BATTERY CELLS BY SKEWNESS ~S404

END

FIG.10

```
                    ┌──────────────┐
                    │    START     │
                    └──────┬───────┘
                           │
                           ▼
     ┌─────────────────────────────────────────────┐
     │       DETERMINE WHETHER FOURTH DIAGNOSIS     │
     │         DEVIATION OF EACH OF PLURALITY OF     │  ~S501
     │      BATTERY CELLS EXCEED UPPER THRESHOLD     │
     └─────────────────────┬───────────────────────┘
                           │
                           ▼
     ┌─────────────────────────────────────────────┐
     │  CALCULATE ACCUMULATIVE DEVIATION BY ACCUMULATING │
     │     FIRST DIAGNOSIS DEVIATION FROM POINT WHEN │  ~S502
     │  FOURTH DIAGNOSIS DEVIATION EXCEED UPPER THRESHOLD │
     └─────────────────────┬───────────────────────┘
                           │
                           ▼
     ┌─────────────────────────────────────────────┐
     │  DIAGNOSE BATTERY CELL AS ABNORMAL BATTERY CELL │
     │   BY DETERMINING WHETHER ACCUMULATIVE DEVIATION │  ~S503
     │   OF EACH BATTERY CELL EXCEED THRESHOLD DEVIATION │
     └─────────────────────┬───────────────────────┘
                           │
                           ▼
                    ┌──────────────┐
                    │     END      │
                    └──────────────┘
```

FIG.11

2000

2200

MEMORY

2400

COMMUNICATION I/F

MCU

2100

INPUT/OUTPUT I/F

2300

FIG.12

## INTERNATIONAL SEARCH REPORT

| International application No. |
| --- |
| **PCT/KR2024/005541** |

| **A.** | **CLASSIFICATION OF SUBJECT MATTER** |
| --- | --- |

**G01R 31/392**(2019.01)i; **G01R 31/396**(2019.01)i; **G01R 31/385**(2019.01)i; **G01R 19/00**(2006.01)i; **G01R 19/165**(2006.01)i; **G01R 19/30**(2006.01)i; **G01R 31/374**(2019.01)i; **H01M 10/0525**(2010.01)i; **B60L 58/16**(2019.01)i

According to International Patent Classification (IPC) or to both national classification and IPC

| **B.** | **FIELDS SEARCHED** |
| --- | --- |

Minimum documentation searched (classification system followed by classification symbols)

G01R 31/392(2019.01); B60L 3/00(2006.01); B60L 58/20(2019.01); G01R 19/00(2006.01); G01R 31/36(2006.01); G01R 31/382(2019.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 이동 평균(moving average), 편차(deviation), 누적 (accumulate)

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| Y | KR 10-2022-0074797 A (LG ENERGY SOLUTION, LTD.) 03 June 2022 (2022-06-03)<br>See paragraphs [0044]-[0166], claims 1-2 and figure 1. | 1-18 |
| Y | KR 10-2022-0146255 A (LG ENERGY SOLUTION, LTD.) 01 November 2022 (2022-11-01)<br>See paragraphs [0072]-[0161]. | 1-18 |
| A | KR 10-2021-0022417 A (LG CHEM, LTD.) 03 March 2021 (2021-03-03)<br>See paragraphs [0033]-[0043]. | 1-18 |
| A | JP 2002-334722 A (MATSUSHITA ELECTRIC IND. CO., LTD. et al.) 22 November 2002 (2002-11-22)<br>See paragraphs [0018]-[0039]. | 1-18 |
| A | CN 114518539 A (BEIJING JIAOTONG UNIVERSITY) 20 May 2022 (2022-05-20)<br>See paragraphs [0029]-[0039]. | 1-18 |

| ☐ Further documents are listed in the continuation of Box C. | ☑ See patent family annex. |
| --- | --- |

| \* | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **30 July 2024** | **30 July 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

<div align="center">

**INTERNATIONAL SEARCH REPORT**
**Information on patent family members**

</div>

International application No.

**PCT/KR2024/005541**

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | EP | 4152021 | A4 | 03 January 2024 |
| | | | | JP | 2023-519949 | A | 15 May 2023 |
| | | | | JP | 7483922 | B2 | 15 May 2024 |
| | | | | KR | 10-2684286 | B1 | 11 July 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2022-0146255 | A | 01 November 2022 | | None | | |
| KR | 10-2021-0022417 | A | 03 March 2021 | KR | 10-2649989 | B1 | 20 March 2024 |
| JP | 2002-334722 | A | 22 November 2002 | | None | | |
| CN | 114518539 | A | 20 May 2022 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230068627